# EUROPÄISCHE PATENTSCHRIFT

(11) **EP 3 808 563 B1**
(45) Veröffentlichungstag und Bekanntmachung des Hinweises auf die Patenterteilung: **11.09.2024**
(21) Anmeldenummer: 20200092.3
(22) Anmeldetag: 05.10.2020
(51) Int. Cl.: B41F 15/42, B41F 15/46, B41F 33/00, B41F 33/16, H05K 3/12

(54) **COMPUTERIMPLEMENTIERTES VERFAHREN ZUR STEUERUNG EINER SIEBDRUCKMASCHINE SOWIE COMPUTERGESTEUERTE SIEBDRUCKMASCHINE**
COMPUTER-IMPLEMENTED METHOD FOR CONTROLLING A SCREEN PRINTING MACHINE AS WELL AS COMPUTER-CONTROLLED SCREEN PRINTING MACHINE
PROCÉDÉ MISE EN OEUVRE PAR UN ORDINATEUR PERMETTANT DE COMMANDER UNE MACHINE D'IMPRESSION PAR SÉRIGRAPHIE AINSI QUE MACHINE D'IMPRESSION PAR SÉRIGRAPHIE COMMANDÉE PAR UN ORDINATEUR

(30) Priorität: 15.10.2019 DE 102019127817
(43) Veröffentlichungstag der Anmeldung: 21.04.2021
(73) Patentinhaber: Lambotec GmbH, 56271 Kleinmaischeid (DE)
(72) Erfinder:
(74) Vertreter: Müller-Boré & Partner Patentanwälte PartG mbB

(56) Entgegenhaltungen:
- EP-A1- 3 549 768
- EP-A2- 0 423 428
- WO-A1-02/00437
- WO-A1-2014/013592
- WO-A1-2014/080010
- WO-A2-2012/164233
- JP-A- 2000 062 139
- JP-A- H01 141 739
- US-A- 5 001 979
- US-A- 5 421 256
- US-B2- 9 050 790

## Beschreibung

### Technisches Gebiet

Die Erfindung betrifft ein computerimplementiertes Verfahren zur Steuerung einer Siebdruckmaschine und eine computergesteuerte Siebdruckmaschine.

### Stand der Technik

Aus dem Stand der Technik sind vielfältige Arten von Siebdruckverfahren und Siebdruckmaschinen bekannt.

Bei bekannten Siebdruckmaschinen werden für das Druckergebnis wesentliche Einstellungen, beispielsweise die Geschwindigkeit, der Anpressdruck oder der Anlegewinkel der Rakel die das Druckmedium durch das Sieb auf das zu bedruckende Substrat drückt, manuell eingestellt und gegebenenfalls aufgrund einer visuellen Kontrolle des Druckbildes angepasst. Dadurch ist die gedruckte Beschichtung weder ausreichend homogen noch ausreichend reproduzierbar für funktionale Anwendungen, beispielsweise gedruckte Batterien, Bildschirme, Photovoltaikmodule oder Heizmodule.

Bei bekannten Siebdruckmaschinen nutzt sich die Gummilippe am Ende der Rakel, mit der das Druckmedium durch das Sieb gedrückt wird, im Laufe des Betriebs ab, sodass sich die Form und der Flächeninhalt der Auflagefläche ändern. Dadurch ändert sich auch der Anpressdruck der Rakel auf das Sieb und folglich die Dicke und Qualität der gedruckten Schicht.

Die Patentanmeldung WO2012164233 A2 beschreibt eine Siebdruckmaschine und ein Siebdruckverfahren. Das Siebdruckverfahren umfasst eine Prüfung des Druckergebnisses mit einer Inspektionsvorrichtung, um auf Basis des Prüfergebnisses Parameter der Siebdruckmaschine zu steuern. Als einzige Kontrollmethode offenbart WO2012164233 A2 eine optische Prüfung des Druckergebnisses, sodass funktionalisierte Druckerzeugnisse wie beispielsweise elektronische Bauteile nicht umfassend kontrolliert werden können. Ferner offenbart WO2012164233 A2 auch nicht, welche Eingangsparameter wie verarbeitet werden, um den Druckvorgang zu steuern.

Die Patentanmeldung EP1080889 A2 beschreibt ein Siebdruckverfahren, bei dem der Druck, mit dem die Druckpaste aus dem Druckkopf ausgetrieben wird, während des Druckvorgangs einstellbar ist. Der Druck kann insbesondere auf Basis eines überprüften Druckergebnisses angepasst werden, wobei die Prüfung auch hier eine optische Prüfung ist. Analog kann auch eine Bewegungsgeschwindigkeit des Druckkopfes oder des Siebs eingestellt werde. Außer dem Austrieb-Druck und der Bewegungsgeschwindigkeit von Druckkopf oder Sieb beschreibt EP1080889 A2 keine Parameter des Druckprozesses, die automatisch gesteuert werden.

Die Schrift WO2014080010 A1 bzw. US 9 050 790 B2 beschreibt eine Siebdruckmaschine mit einer Sensoranordnung zur Bestimmung eines während des Druckvorgangs auf das Substrat wirkenden Drucks. Der Druck auf das Substrat kann beispielsweise durch eine automatische Anpassung einer Andrückkraft eines Druckwerkzeugs, beispielsweise einer Rakel, konstant gehalten werden. Insbesondere bei elastisch verformbaren und dünnen Substraten, wie beispielsweise Folien, gestaltet sich eine Messung des auf das Substrat wirkenden Drucks jedoch technisch aufwändig.

Die Patentanmeldung WO2006091845A2 beschreibt eine Siebdruckmaschine, umfassend eine Fluidübertragungskomponente mit Poren. Die Druckmaschine kann ferner eine Rakel umfassen. Die Position der Rakel in Bezug auf die Fluidübertragungskomponente kann so konfiguriert werden, dass sie nach Ermessen des Bedieners der Vorrichtung eingestellt wird. WO2006091845A2 offenbart also lediglich eine Druckmaschine, bei der eine Rakel-Position bestenfalls manuell vom Bediener angepasst werden kann. Eine manuelle Anpassung erfolgt jedoch häufig zu spät und ist unpräzise, sodass dadurch ein qualitativ hochwertiges Druckergebnis nicht zuverlässig erzielt werden kann.

Die Druckschrift EP2999595B1 offenbart eine Anlage zur Herstellung von dreidimensionalen Siebdrucken. Die Anlage kann mit kontaktlosen Messvorrichtungen ausgestattet sein, mittels derer die Positionen und Druckverhältnisse von Druck- und Flutrakelunterkanten der Rakel erfasst, ausgewertet und deren Messergebnisse in die Einstellung insbesondere der Rakelposition der Rakelsteuerung eingebunden werden können, um eine parallele Ausrichtung der Rakel zu dem Siebgewebe sicherzustellen. Die Positionsbestimmung und Verstellbarkeit der Rakel dient primär der 3D-Druck-Funktionalität der Anlage und führt bei der Herstellung ebener Drucke wahrscheinlich nicht zu großen Qualitätsvorteilen.

### Technische Aufgabe

Die Aufgabe der Erfindung ist es, ein einfach umzusetzendes Verfahren zur Steuerung einer Siebdruckmaschine und ein kostengünstige Siebdruckmaschine bereitzustellen, um funktionale Schichten effizient, zuverlässig und mit hoher Präzision zu drucken.

### Technische Lösung

Der Gegenstand der vorliegenden Erfindung stellt ein Verfahren gemäß Anspruch 1 bereit, das die technische Aufgabe löst. Ebenso wird die Aufgabe durch eine Siebruckmaschine gemäß Anspruch 9 gelöst. Vorteilhafte Ausgestaltungen ergeben sich aus den abhängigen Ansprüchen.

### Beschreibung der Ausführungsarten

Das computerimplementierte Verfahren gemäß der vorliegenden Erfindung umfasst die Steuerung einer Siebdruckmaschine mit zumindest einem Sieb, zumindest einer Rakel mit einer an der Rakel befestigten Rakellippe, wobei die Rakellippe eine Kontaktfläche mit einem Flächeninhalt zum Kontakt mit dem Sieb umfasst, zumindest einem Rakelantrieb zur Translation der Rakel relativ zu dem Sieb entlang einer zu dem Sieb parallelen X-Achse und entlang einer zu dem Sieb orthogonalen Z-Achse sowie zur Rotation der Rakel relativ zu dem Sieb um eine zur X-Achse und zur Z-Achse orthogonalen Y-Achse und zumindest einem Computergerät zur Steuerung der Siebdruckmaschine.

Die vorgenannten Komponenten der Siebdruckmaschine können beispielsweise wie bei konventionellen Siebdruckmaschinen aufgebaut und miteinander verbunden sein. Darüber hinaus kann die Siebdruckmaschine weitere, insbesondere aus konventionellen Siebdruckmaschinen in ihrem Aufbau und ihrer Funktion bekannte, Komponenten aufweisen.

Die Siebdruckmaschine umfasst zumindest einen kommunikativ mit dem Computergerät verbundenen Sensor zur Bestimmung des Flächeninhalts der Kontaktfläche der Rakellippe.

Das Verfahren umfasst den Schritt des Druckens einer Druckpaste mit der Rakellippe durch das Sieb zur Erzeugung einer Drucklage aus der Druckpaste auf einem Substrat, wobei die Rakel durch den zumindest einen Rakelantrieb mit einer Arbeitsgeschwindigkeit entlang der X-Achse bewegt wird, in einem Arbeitswinkel zur Z-Achse ausgerichtet ist, und mit einer Arbeitskraft entlang der Z-Achse auf das Sieb gedrückt wird.

Das Drucken wird vorzugsweise mehrfach wiederholt, um auf dem Substrat eine Schicht aus mehreren Drucklagen aufzubauen. Die Schicht kann beispielsweise eine funktionale Schicht einer gedruckten elektronischen Komponente, zum Beispiel eine dielektrische Schicht eines gedruckten Kondensators, umfassen.

Das Verfahren umfasst erfindungsgemäß folgende Schritte: ein automatisches Bestimmen des Flächeninhalts der Kontaktfläche der Rakellippe mit dem zumindest einen Sensor nach dem Drucken einer Anzahl von Drucklagen und ein automatisches Nachstellen der Arbeitskraft abhängig von dem Flächeninhalt zum Einstellen eines vorgegebenen Soll-Anpressdrucks der Rakellippe auf das Sieb nach dem Bestimmen.

Im einfachsten Fall entspricht die nachgestellte Arbeitskraft dem Produkt des Soll-Anpressdrucks mit dem Flächeninhalt, gegebenenfalls ergänzt um weitere Parameter, die sich beispielsweise aus einer Verformung der Rakellippe während des Druckens ergeben können. Die weiteren Parameter können für gegebene Druckeinstellungen sowie Materialeigenschaften und Geometrie der Rakellippe beispielsweise durch Kalibrierung bestimmt und/oder berechnet werden.

Das möglichst genaue Einhalten des Soll-Anpressdrucks ist für ein qualitativ hochwertiges Druckergebnis von großer Bedeutung, da der Anpressdruck einerseits jederzeit groß genug sein muss, um eine vorgegebene Massenstromdichte der Druckpaste zuverlässig durch das Sieb zu pressen, sodass eine fehlstellenfreie Drucklage entsteht. Ein fehlstellenfreier Druck ist insbesondere bei der Herstellung funktionaler Schichten von Bedeutung, da Fehlstellen einen Funktionsverlust, beispielsweise durch Korrosion bei einer Fehlstelle in einer Korrosionsschutzschicht oder durch einen Kurzschluss bei einer Fehlstelle in einer elektrischen Isolatorschicht, bewirken können.

Andererseits darf der Anpressdruck aber auch nicht zu hoch sein, da es sonst zu einem erhöhten Verschleiß von Rakel und/oder Sieb kommt. Außerdem kann ein zu hoher Anpressdruck bereits gedruckte Drucklagen und/oder das Substrat beschädigen, was insbesondere beim Druck funktionaler Schichten und/oder der Verwendung empfindlicher Substrate, wie beispielsweise Folien, problematisch ist.

Das Bestimmen und das Nachstellen erfolgen vorzugsweise mehrmals im Laufe des Verfahrens, jeweils nach dem Drucken einer, insbesondere konstanten, Anzahl von Drucklagen.

Je nach Druckeinstellungen sowie Materialeigenschaften von Rakellippe, Druckpaste und Sieb kann die Anzahl von Drucklagen, die jeweils vor einem automatischen Bestimmen gedruckt werden, so gewählt werden, dass ein Bestimmen erfolgt, sobald eine signifikante Änderung des Flächeninhalts und somit ein signifikanter Verschleiß der Rakellippe zu erwarten ist. Dadurch wird verhindert, dass es zu einem unbemerkten Verschleiß der Rakellippe, der die Druckqualität beeinträchtigen könnte, kommt. Andererseits sollte die Anzahl von Drucklagen auch nicht so klein gewählt sein, dass das Bestimmen vor einer signifikanten Änderung des Flächeninhalts erfolgt, damit der Druckvorgang nicht unnötig oft für ein Bestimmen unterbrochen wird.

Der Flächeninhalt kann zusammen mit der Anzahl der gedruckten Drucklagen, vorzugsweise mit weiteren Parameter des Verfahrens, wie beispielsweise Materialeigenschaften der Rakellippe, der Druckpaste und/oder des Siebs, der Arbeitsgeschwindigkeit, dem Arbeitswinkel und/oder der Arbeitskraft, gespeichert werden. Dadurch kann der Verschleiß der Rakellippe dokumentiert werden. Außerdem kann automatisch vorhergesagt werden, wann die Rakellippe ausgehend von dem bisherigen Verschleiß voraussichtlich ausgetauscht werden muss, sodass eine Ersatzrakellippe rechtzeitig bereitgestellt werden kann.

Aus einer gespeicherten Entwicklung des Flächeninhalts kann auch die Anzahl der Drucklagen, nach der das nächste Bestimmen erfolgen wird, automatisch so angepasst werden, dass das nächste Bestimmen erfolgt, sobald eine signifikante Änderung des Flächeninhalts und somit ein signifikanter Verschleiß der Rakellippe zu erwarten ist.

Das Verfahren umfasst weiterhin folgende Schritte: ein automatisches Verstellen des Arbeitswinkels um ein vorgegebenes Winkelintervall, sobald der Flächeninhalt einen Maximalflächeninhalt überschreitet und ein automatisches Zurücksetzen der Arbeitskraft zum Einstellen des Soll-Anpressdrucks nach dem Verstellen. Das Verstellen und Zurücksetzen können insbesondere im Laufe des Verfahrens mehrmals erfolgen, immer dann, wenn der Flächeninhalt den Maximalflächeninhalt überschreitet.

Das Verstellen verhindert, dass durch einen zu großen Flächeninhalt eine sehr große Kraft zur Einhaltung des Soll-Anpressdrucks aufgebracht werden muss, die den Energieverbrauch und Verschleiß des Rakelantriebs erhöhen und den Rakelantrieb beschädigen könnte. Außerdem wird durch das Verstellen eine gleichmäßigere Abnutzung der Rakellippe erreicht, sodass eine Rakellippe länger genutzt werden kann, und/oder eine weichere Rakellippe eingesetzt werden kann, um das Sieb und/oder Substrat zu schonen.

Nach dem Verstellen steht eine frische Kante der Rakellippe mit einem verringerten Flächeninhalt für das weitere Drucken zur Verfügung. Daher muss die Arbeitskraft zurückgesetzt werden, um weiterhin den Soll-Anpressdruck zu bewirken. Im einfachsten Fall wird die Arbeitskraft auf eine Ausgangskraft vom Beginn des Druckens zurückgesetzt.

Das automatische Verstellen des Arbeitswinkels erfolgt vorzugsweise in einer ersten Richtung, bis der Arbeitswinkel einen ersten Grenzwinkels passiert. Bei Passieren des ersten Grenzwinkels erfolgt vorzugsweise ein automatisches Zurücksetzen des Arbeitswinkels auf einen Ausgangswinkel vom Beginn des Druckens. Das automatische Verstellen erfolgt vorzugsweise nach dem Zurücksetzen des Arbeitswinkels in einer der ersten Richtung entgegengesetzten, zweiten Richtung, bis der Arbeitswinkel einen zweiten Grenzwinkel passiert.

Die Grenzwinkel sind vorteilhafterweise so gewählt, dass die Rakel zwischen den Grenzwinkeln ausreichend steil zum Sieb ausgerichtet ist, um die Druckpaste zuverlässig mit einer vorgegebenen Massenstromdichte durch das Sieb zu pressen. Wenn die Rakel zu flach zum Sieb ausgerichtet ist, besteht die Gefahr, dass zwischen der Rakellippe und dem Sieb keine ausreichend große Menge der Druckpaste an die Kontaktfläche gelangt, um ein fehlstellenfreies Drucken zu ermöglichen.

Indem der Arbeitswinkel zunächst in der ersten Richtung und dann vom Ausgangswinkel aus in der zweiten Richtung verstellt wird, kann die Rakellippe optimal ausgenutzt werden, sodass sie besonders lange genutzt werden und/oder besonders weich sein kann.

Das automatische Bestimmen des Flächeninhalts umfasst vorzugsweise ein automatisches Ermitteln einer Abriebdicke der Rakellippe mit dem zumindest einen Sensor und ein automatisches Berechnen der Kontaktfläche aus der Abriebdicke und einer Ursprungsform der Rakellippe. Bei einer bekannter, beispielsweise quaderförmigen, Ursprungsform kann der Flächeninhalt auf einfache Weise trigonometrisch aus dem Arbeitswinkel, den Ursprungsmaßen der Rakellippe und der Abriebdicke berechnet werden.

Unter Abriebdicke wird erfindungsgemäß die Materialdicke senkrecht zur Kontaktfläche verstanden, die von der Rakellippe durch das Drucken im Verhältnis zu den Ursprungsmaßen der Rakellippe abgetragen wurde. Die Begriffe Ursprungsform und Ursprungsmaße beziehen sich auf die Form und Maße der Rakellippe, bevor sie in dem Verfahren verwendet wird und dadurch verschleißt.

Der Flächeninhalt könnte auch direkt, beispielsweise mit einem bildgebenden Sensor und einer automatischen Vermessung eines von dem Sensor aufgenommenen Bilds, zum Beispiel mit automatischer Objekterkennung, erfolgen. Da sich die Kontaktfläche jedoch in Farbe und Struktur in der Regel nicht wesentlich von der umgebenden Rakellippe unterscheidet, ist eine automatische Vermessung eines Bildes der Kontaktfläche technisch aufwendig und unzuverlässig.

Demgegenüber kann die Abriebdicke mit technisch einfachen Mitteln präzise bestimmt werden, beispielsweise mit einem bildgebenden Sensor und einer automatischen Vermessung eines von dem Sensor aufgenommenen Bilds einer entlang der X-Achse und der Z-Achse ausgerichteten Seitenfläche der Rakellippe, zum Beispiel mit automatischer Objekterkennung. Für eine besonders einfache und präzise Bestimmung der Abriebdicke kann auf der Seitenfläche der Rakellippe eine Längenskala angebracht sein. Um die Abriebdicke unabhängig vom Arbeitswinkel anzeigen zu können, kann die Längenskala aus Kreisbögen bestehen, die jeweils Punkte mit einem gleichen Abstand von der ursprünglichen, zum Kontakt mit dem Sieb vorgesehenen Ecke der Seitenfläche miteinander verbinden.

Das automatische Ermitteln der Abriebdicke umfasst vorzugsweise ein automatisches Messen eines Referenzabstands der Rakellippe von dem zumindest einen Sensor bei bekannter Referenzabriebdicke der Rakellippe, insbesondere am Anfang des Druckens oder direkt nach einem Verstellen des Arbeitswinkels, wenn die Referenzabriebdicke null ist, ein automatisches Messen eines Abstands der Rakellippe von dem zumindest einen Sensor und ein automatisches Berechnen der Abriebdicke aus der Referenzabriebdicke dem Referenzabstand und dem Abstand.

Das automatische Messen des Referenzabstands erfolgt vorzugsweise, während die Rakel in einem Referenzmesswinkel zur Z-Achse ausgerichtet ist, und das automatische Messen des Abstands erfolgt vorzugsweise, während die Rakel in einem Messwinkel zur Z-Achse ausgerichtet ist.

Der Referenzmesswinkel entspricht vorzugsweise dem Messwinkel. In diesem Fall können der Referenzabstand und der Abstand auf einfache Weise mit dem gleichen Sensor gemessen werden, ohne den Sensor dafür bewegen zu müssen und die Abriebdicke lässt sich besonders einfach berechnen als Differenz des Referenzabstands von dem Abstand.

Der Referenzwinkel und/oder der Messwinkel entspricht vorzugsweise dem Arbeitswinkel. Daraus ergibt sich der Vorteil, dass keine Winkelverstellung notwendig ist, um den Referenzabstand und/oder Abstand zu messen. Eine Winkelverstellung würde zusätzliche Zeit beanspruchen und könnte, wenn sie nicht ausreichend präzise ist, Messfehler induzieren. Besonders bevorzugt entsprechen der Referenzwinkel und der Messwinkel dem Arbeitswinkel.

Der Referenzwinkel und/oder der Messwinkel kann von dem Arbeitswinkel verschieden sein, beispielsweise um dadurch den zumindest einen Sensor an einem leichter zugänglichen Ort der Siebdruckmaschine anbringen zu können. Beispielsweise können der Referenzwinkel und/oder der Messwinkel, insbesondere der Referenzwinkel und der Messwinkel, um 180° von dem Arbeitswinkel verschieden sein. Daraus ergibt sich der Vorteil, dass der zumindest eine Sensor auf der dem Sieb abgewandten Seite der Rakel angebracht sein kann. Dieser Bereich der Siebdruckmaschine ist in der Regel leicht zugänglich.

Die Messung des Referenzabstand und/oder des Abstands erfolgt vorzugsweise entlang der Z-Achse, da eine präzise Ausrichtung der Messrichtung entlang der, in der Regel vertikalen, Z-Achse technisch einfach umzusetzen ist.

Das Messen des Referenzabstands und/oder des Abstands erfolgt vorzugsweise, während die zumindest eine Rakel mit Hilfe des zumindest einen Rakelantriebs um die Y-Achse über ein Winkelintervall rotiert wird. Aus dem sich ergebenden Abstandsverlauf innerhalb des Winkelintervalls lässt sich der Referenzabstand und/oder Abstand berechnen, ohne dass eine genaue Winkelpositionierung der Rakel notwendig wäre. Außerdem kann auf diese Weise auch eine Form der Rakellippe bestimmt werden, um deren Verschleiß genauer überwachen zu können. Eine Form der Rakel Lippe könnte beispielsweise auch durch eine Abstandsmessung mithilfe eines Scanners, insbesondere eines Laserscanners, bestimmt werden.

Das Verfahren umfasst bevorzugt den Schritt eines automatischen Kontrollierens zumindest einer physikalischen Eigenschaft einer mit der Siebdruckmaschine auf das Substrat gedruckten Schicht mit einer Kontrollvorrichtung der Siebdruckmaschine, und den Schritt eines automatischen Anpassens der Arbeitskraft, des Arbeitswinkels und/oder der Arbeitsgeschwindigkeit der Rakel und/oder eines Siebabstands zwischen dem Sieb und dem Substrat bei einer Abweichung der physikalischen Eigenschaft von einer zugehörigen Soll-Eigenschaft.

Durch das in das Verfahren integrierte automatische Kontrollieren können die Verfahrensparameter bei einer Abweichung der gedruckten Schicht von ihren Soll-Eigenschaften schnell und automatisch angepasst werden, um Fehldrucke zu vermeiden. Dies ist insbesondere bei funktionalen Schichten von großer Bedeutung, da eine Fehlfunktion einer Schicht hohe Folgekosten nach sich ziehen kann.

Die physikalische Eigenschaft umfasst vorzugsweise eine Schichtdicke der Schicht entlang der Z-Achse, eine elektrische Leitfähigkeit der Schicht entlang der Z-Achse und/oder ein spezifischer Flächenwiderstand der Schicht, eine Homogenität der Schichtdicke und/oder der elektrischen Leitfähigkeit entlang einer von der X-Achse und der Y-Achse aufgespannten XY-Ebene.

Die genannten physikalischen Eigenschaften sind insbesondere bei der Herstellung von elektronischen funktionalen Schichten, wie beispielsweise Kondensatoren, Elektrolumineszenzschichten oder elektrischen Widerstandsschichten oder Isolatorschichten, von großer Bedeutung.

Die Erfindung betrifft eine computergesteuerte Siebdruckmaschine zur Ausführung eines erfindungsgemäßen Verfahrens mit zumindest einem Sieb, zumindest einer Rakel mit einer an der Rakel befestigten Rakellippe, wobei die Rakellippe eine Kontaktfläche mit einem Flächeninhalt zum Kontakt mit dem Sieb umfasst, zumindest einem Rakelantrieb zur Translation der Rakel relativ zu dem Sieb entlang einer zu dem Sieb parallelen X-Achse und entlang einer zu dem Sieb orthogonalen Z-Achse sowie zur Rotation der Rakel relativ zu dem Sieb um eine zur X-Achse und zur Z-Achse orthogonalen Y-Achse und zumindest einem Computergerät zur Steuerung der Siebdruckmaschine.

Die vorgenannten Komponenten der Siebdruckmaschine können beispielsweise wie bei konventionellen Siebdruckmaschinen aufgebaut und miteinander verbunden sein. Darüber hinaus kann die Siebdruckmaschine weitere, insbesondere aus konventionellen Siebdruckmaschinen in ihrem Aufbau und ihrer Funktion bekannte, Komponenten aufweisen.

Die Siebdruckmaschine umfasst zumindest einen kommunikativ mit dem Computergerät verbundenen Sensor zur Bestimmung des Flächeninhalts der Kontaktfläche der Rakellippe. Die Vorteile einer Bestimmung des Flächeninhalts sind oben zum erfindungsgemäßen Verfahren ausführlich beschrieben.

Der zumindest eine Sensor umfasst vorzugsweise einen Abstandssensor, besonders bevorzugt einen Laser-Abstandssensor, zur Messung eines Abstands der Kontaktfläche von dem zumindest einen Sensor. Mithilfe eines Abstandssensors lässt sich der Flächeninhalt wie oben zum erfindungsgemäßen Verfahren beschrieben auf einfache Weise präzise bestimmen. Ein Laser-Abstandssensor erlaubt dabei eine besonders hohe Genauigkeit.

Der zumindest eine Sensor kann einen bildgebenden Sensor, insbesondere eine Kamera, umfassen. Mit einem bildgebenden Sensor kann der Flächeninhalt mit den oben zum erfindungsgemäßen Verfahren beschriebenen Methoden bestimmt werden.

Der zumindest eine Sensor ist vorzugsweise zur Abstandsmessung an zumindest zwei entlang der Y-Achse voneinander beabstandeten Bereichen der Rakellippe ausgestaltet. Beispielsweise wenn die Rakel nicht exakt in ihrer vorgesehenen Position in der Siebdruckmaschine eingebaut ist kann dadurch ein entlang der Y-Achse ungleichmäßiger Verschleiß der Rakellippe auftreten. Durch eine Messung in den zumindest zwei Bereichen kann ein solcher ungleichmäßiger Verschleiß automatisch festgestellt werden. Daraufhin kann automatisch beispielsweise eine Position der Rakel korrigiert werden und/oder eine Warnmeldung an einen Bediener der Siebdruckmaschine ausgegeben werden.

In der Regel verläuft ein entlang der Y-Achse ungleichmäßiger Verschleiß der Rakellippe linear. Daher ist es in der Regel ausreichend, eine Abstandsmessung an genau zwei voneinander beanstandeten Bereichen vorzusehen.

Zur Abstandsmessung in den zumindest zwei Bereichen umfasste die Siebdruckmaschine beispielsweise zumindest zwei entlang der Y-Achse voneinander beabstandete Sensoren.

Die Siebdruckmaschine umfasst vorzugsweise einen mit dem Computergerät kommunikativ verbundenen Siebantrieb zur Translation des Siebs entlang der Z-Achse relativ zu dem Substrat, einen mit dem Computergerät kommunikativ verbundenen Druckplattenantrieb zur Translation einer Druckplatte zur Aufnahme des zu bedruckenden Substrats entlang der X-Achse relativ zu dem Sieb, zumindest eine Flutrakel zur Verteilung der Druckpaste auf dem Sieb und einen mit dem Computergerät kommunikativ verbundenen Flutrakelantrieb zur Translation der Flutrakel relativ zu dem Sieb entlang der X-Achse und entlang der Z-Achse sowie zur Rotation der Flutrakel relativ zu dem Sieb um die Y-Achse und/oder zumindest einen die zumindest eine Rakel und die zumindest eine Flutrakel tragenden Rahmen und einen mit dem Computergerät kommunikativ verbundenen Rahmenantrieb zur Translation des Rahmens relativ zu dem Sieb entlang der Z-Achse.

Durch einen, mehrere oder alle der vorgenannten Antriebe sind wesentliche Funktionen der Siebdruckmaschine durch das Computergerät automatisch steuerbar. Dadurch ist eine präzisere und zuverlässigere Steuerung möglich als bei üblichen Siebdruckmaschinen, bei denen die Funktionen zumindest teilweise noch manuell gesteuert sind. Insbesondere zum Druck funktionaler Schichten ist eine sehr genaue Positionierung der einzelnen Drucklagen relativ zueinander sowie eine hohe Druckqualität der einzelnen Drucklagen notwendig, die mit üblichen Siebdruckmaschinen in der Regel nicht erreichbar sind.

Der zumindest eine Rakelantrieb, ein Siebantrieb, ein Druckplattenantrieb, ein Flutrakelantrieb und/oder ein Rahmenantrieb umfasst vorzugsweise eine Anzahl von mit dem Computergerät kommunikativ verbundenen Elektromotoren, bevorzugt Servomotoren. Besonders bevorzugt umfasst jeder der genannten Antriebe jeweils eine Anzahl von mit dem Computergerät kommunikativ verbundenen Elektromotoren, insbesondere Servomotoren. Elektromotoren haben gegenüber den in üblichen Siebdruckmaschinen verwendeten hydraulischen Antrieben den Vorteil einer präziseren Positionierung der angetriebenen Bauteile.

Servomotoren haben den besonderen Vorteil, dass sie durch einen integrierten Positionssensor eine exakte Kontrolle der Winkelposition ihrer Motorwelle sowie der Drehgeschwindigkeit und Beschleunigung erlauben.

Die Siebdruckmaschine umfasst vorzugsweise zumindest eine kommunikativ mit dem Computergerät verbundene Kontrollvorrichtung zur Kontrolle zumindest einer physikalischen Eigenschaft einer mit der Siebdruckmaschine auf das Substrat gedruckten Schicht. Die physikalische Eigenschaft umfasst bevorzugt eine Schichtdicke der Schicht entlang der Z-Achse, eine elektrische Leitfähigkeit der Schicht entlang der Z-Achse und/oder ein spezifischer Flächenwiderstand der Schicht, eine Homogenität der Schichtdicke und/oder der elektrischen Leitfähigkeit entlang einer von der X-Achse und der Y-Achse aufgespannten XY-Ebene umfasst.

Die Vorteile der Kontrolle sind oben zum erfindungsgemäßen Verfahren beschrieben.

Zur Messung der Schichtdicke und/oder der Homogenität der Schichtdicke kann die Kontrollvorrichtung beispielsweise zumindest einen Abstandssensor, ein Interferometer, ein Profilometer und/oder ein Kamerasystem umfassen.

Die zumindest eine Kontrollvorrichtung kann beispielsweise zur Messung des spezifischen Flächenwiderstandes nach der Vier-Punkt-Methode und/oder nach der Van-der-Pauw-Messmethode ausgelegt sein.

### Kurze Beschreibung der Zeichnungen

Weitere Vorteile, Ziele und Eigenschaften der Erfindung werden anhand nachfolgender Beschreibung und anliegender Zeichnungen erläutert, in welchen beispielhaft erfindungsgemäße Gegenstände dargestellt sind. Merkmale, welche in den Figuren wenigstens im Wesentlichen hinsichtlich ihrer Funktion übereinstimmen, können hierbei mit gleichen Bezugszeichen gekennzeichnet sein, wobei diese Merkmale nicht in allen Figuren beziffert und erläutert sein müssen.
Figur 1 zeigt eine schematische, perspektivische Zeichnung einer erfindungsgemäßen Siebdruckmaschine.
Figur 2 zeigt eine schematische, perspektivische Zeichnung einer Druckplatte der Siebdruckmaschine aus Figur 1.
Figur 3 zeigt eine schematische Schnittdarstellung der Rakel einer erfindungsgemäßen Siebdruckmaschine.
Figur 4 zeigt eine weitere schematische Schnittdarstellung der Rakel aus Figur 3.
Figur 5 zeigt eine schematische Darstellung eines erfindungsgemäßen Verfahrens zur Steuerung einer Siebdruckmaschine.

### Fig.1

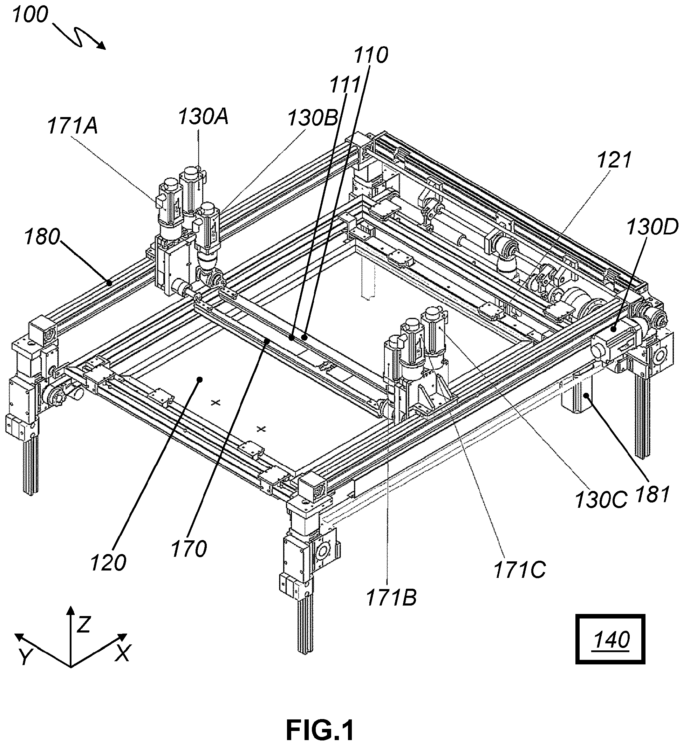

Figur 1 zeigt eine schematische, perspektivische Zeichnung einer erfindungsgemäßen Siebdruckmaschine 100 mit zumindest einem Sieb 120, zumindest einer Rakel 110 mit einer an der Rakel 110 befestigten Rakellippe 111, wobei die Rakellippe 111 eine Kontaktfläche mit einem Flächeninhalt zum Kontakt mit dem Sieb 120 umfasst, zumindest einem Rakelantrieb 130 zur Translation der Rakel 110 relativ zu dem Sieb 120 entlang einer zu dem Sieb 120 parallelen X-Achse und entlang einer zu dem Sieb 120 orthogonalen Z-Achsel sowie zur Rotation der Rakel 110 relativ zu dem Sieb 120 um eine zur X-Achse und zur Z-Achse orthogonalen Y-Achse und zumindest einem Computergerät 140 zur Steuerung der Siebdruckmaschine 100.

Dazu kann das Computergerät 140 kabellose oder kabelgebundenen mit den übrigen Komponenten der Siebdruckmaschine 100 kommunikativ verbunden sein. Der Übersichtlichkeit halber sind die kommunikativen Verbindungen nicht dargestellt.

Der Rakelantrieb 130 umfasst beispielsweise vier Elektromotoren 130A, 130B, 130C, 130D. Davon dienen beispielsweise zwei Elektromotoren 130A, 130C einer vertikalen Translation der Rakel 110 entlang der Z-Achse, ein weiterer Elektromotor 130B einer Rotation der Rakel 110 um die Y-Achse und ein weiterer Elektromotor 130D einer horizontalen Translation der Rakel 110, und vorzugsweise auch einer Flutrakel 170 der Siebdruckmaschine 100, entlang der X-Achse.

Die Siebdruckmaschine 100 umfasst vorzugsweise einen mit dem Computergerät 140 kommunikativ verbundenen Siebantrieb 121 zur Translation des Siebs 120 entlang der Z-Achsel relativ zu dem Substrat

Die Siebdruckmaschine 100 umfasst vorzugsweise eine Flutrakel 170 zur Verteilung der Druckpaste auf dem Sieb 120 und einen mit dem Computergerät 140 kommunikativ verbundenen Flutrakelantrieb 171 zur Translation der Flutrakel 170 relativ zu dem Sieb 120 entlang der X-Achse und entlang der Z-Achsel sowie zur Rotation der Flutrakel 170 relativ zu dem Sieb 120 um die Y-Achse.

Der Flutrakelantrieb 171 umfasst beispielsweise drei Elektromotoren 171A, 171B, 171C. Davon dienen beispielsweise 2 Elektromotoren 171A, 171C einer vertikalen Translation der Flutrakel 170 entlang der Z-Achsel und ein weiterer Elektromotor 171B einer Rotation der Flutrakel 170 um die Y-Achse

Die Siebdruckmaschine 100 umfasst vorzugsweiseeinen die zumindest eine Rakel 110 und die zumindest eine Flutrakel 170 tragenden Rahmen 180 und einen mit dem Computergerät 140 kommunikativ verbundenen Rahmenantrieb 181 zur Translation des Rahmens 180 relativ zu dem Sieb 120 entlang der Z-Achse.

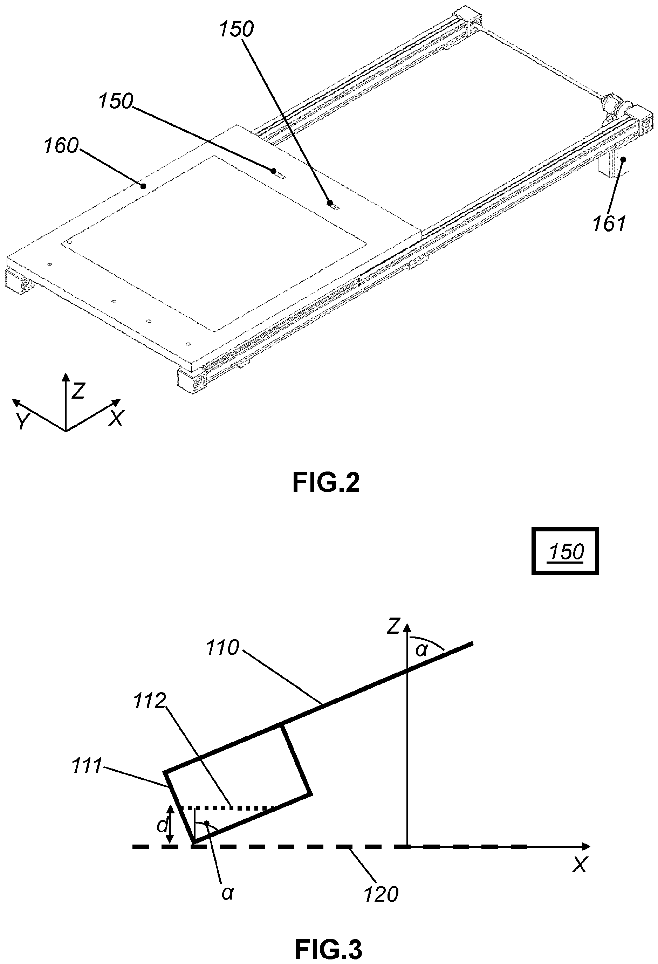

Die Siebdruckmaschine 100 kann ferner eine Druckplatte zur Aufnahme des zu bedruckenden Substrats umfassen, der der Übersichtlichkeit halber separat in Figur 2 gezeigt ist.

### Fig.2

Figur 2 zeigt eine schematische, perspektivische Zeichnung einer Druckplatte 160 der Siebdruckmaschine 100 aus Figur 1. Die Siebdruckmaschine 100 umfasst vorzugsweise einen mit dem Computergerät 140 kommunikativ verbundenen Druckplattenantrieb 161 zur Translation der Druckplatte 160 entlang der X-Achse relativ zu dem Sieb 120.

In der Druckplatte 160 kann beispielsweise zumindest ein kommunikativ mit dem Computergerät 140 verbundener Sensor 150, insbesondere zwei entlang der Y-Achse voneinander beabstandete Sensoren 150, zur Bestimmung des Flächeninhalts der Kontaktfläche der Rakellippe 111 angeordnet sein.

Die Sensoren 150 können beispielsweise als Abstandssensoren, insbesondere Laser-Abstandssensoren, zur Messung eines Abstands der Kontaktfläche von dem jeweiligen Sensor 150 ausgestaltet sein.

Bei der dargestellten Anordnung der Sensoren 150 in der Druckplatte 160 können die Sensoren 150 beispielsweise für eine vertikale Abstandsmessung entlang der Z-Achse^ nach oben ausgelegt sein.

Während des Druckens ist die Rakel 110 zur Z-Achsel mit einem Arbeitswinkel ausgerichtet, und eine Flächennormale der Kontaktfläche der Rakellippe 111 ist entlang der Z-Achsel nach unten ausgerichtet. Dadurch kann die Abstandsmessung bei einem Messwinkel oder Referenzmesswinkel der Rakel 110 zur Z-Achse erfolgen, der dem Arbeitswinkel entspricht. Es ist also keine Winkelverstellung notwendig, die zusätzliche Zeit kosten würde und eine Quelle für Messfehler sein könnte.

Alternativ können die Sensoren 150 auch an einer anderen Position angeordnet sein, beispielsweise oberhalb der Rakel mit einer Messrichtung vertikal nach unten.

### Fig.3

Figur 3 zeigt eine schematische Schnittdarstellung der Rakel 110 einer erfindungsgemäßen Siebdruckmaschine 100 entlang einer XZ-Ebene. Die Rakel 110 ist zum Drucken beispielsweise in einem Arbeitswinkel α zu der Z-Achse ausgerichtet und wird entlang der X-Achse über das Sieb 120 bewegt.

Dabei kommt es zu einem Verschleiß der Rakellippe 111 der Rakel von einer, beispielsweise quaderförmigen, Ursprungsform (mit durchgezogenen Linien dargestellt) zu einer Form, bei der Material von der Rakellippe 111 mit einer Abriebdicke d senkrecht zu einer Kontaktfläche 112 zum Kontakt mit dem Sieb 120 abgerieben ist (gepunktet dargestellt).

Ein Flächeninhalt der Kontaktfläche 112 kann bei bekannten Ursprungsmaßen der Rakellippe 111 trigonometrisch aus der Abriebdicke d und dem Arbeitswinkel α berechnet werden.

Zumindest ein Sensor 150, beispielsweise eine Laser-Abstandssensor, zur Messung eines Abstands de Kontaktfläche 112 von dem Sensor 150, um die Abriebdicke zu berechnen, kann zum Beispiel an der dem Sieb 120 abgewandten Seite der Rakel 110 angebracht sein. An der dem Sieb 120 abgewandten Seite steht in der Regel ausreichen Bauraum zur Anordnung des Sensors 150 zur Verfügung und der Sensor 150 ist, beispielsweise für Wartungsarbeiten, leicht zugänglich.

### Fig.4

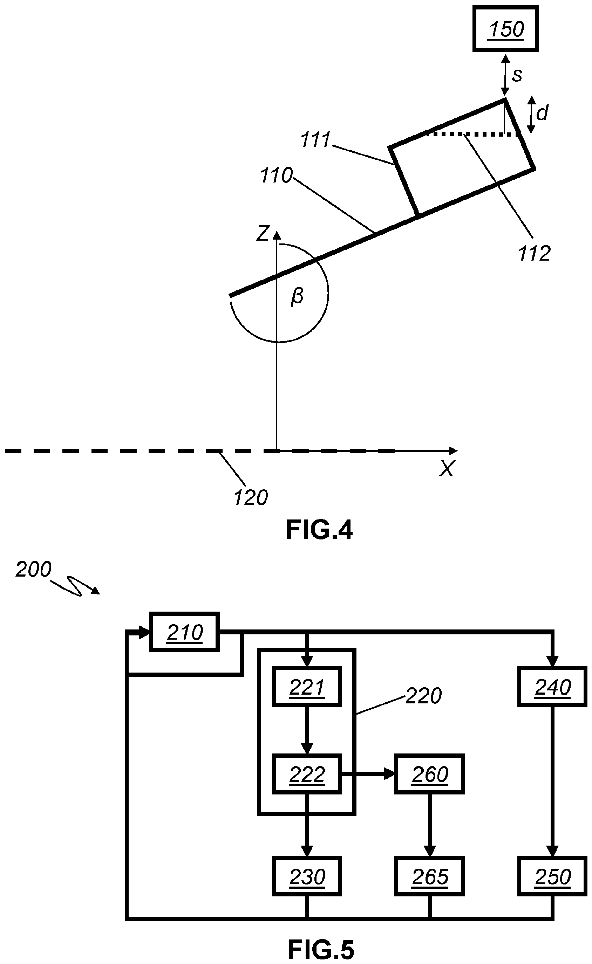

Figur 4 zeigt eine schematische Schnittdarstellung der Rakel 110 aus Figur 3 entlang einer XZ-Ebene. Die Rakel 110 ist zum Messen des Abstands s der Kontaktfläche 112 von dem Sensor 150 beispielsweise in einem Messwinkel β zu der Z-Achse ausgerichtet, wobei der Messwinkel β sich zum Beispiel um 180° von dem Arbeitswinkel α unterscheidet. Dadurch kann der Abstand s entlang der Z-Achse von dem Sensor 150 auf das Sieb 120 gemessen werden. Eine entsprechende Ausrichtung des Sensors an der Z-Achse ist besonders einfach einzustellen.

### Fig.5

Figur 5 zeigt eine schematische Darstellung eines erfindungsgemäßen Verfahrens 200 zur Steuerung einer Siebdruckmaschine mit zumindest einem Sieb, zumindest einer Rakel mit einer an der Rakel befestigten Rakellippe, wobei die Rakellippe eine Kontaktfläche mit einem Flächeninhalt zum Kontakt mit dem Sieb umfasst, zumindest einem Rakelantrieb zur Translation der Rakel relativ zu dem Sieb entlang einer zu dem Sieb parallelen X-Achse und entlang einer zu dem Sieb orthogonalen Z-Achse sowie zur Rotation der Rakel relativ zu dem Sieb um eine zur X-Achse und zur Z-Achse orthogonalen Y-Achse, zumindest einem Computergerät zur Steuerung der Siebdruckmaschine und zumindest einem kommunikativ mit dem Computergerät verbundenen Sensor zur Bestimmung des Flächeninhalts der Kontaktfläche der Rakellippe.

Das Verfahren umfasst ein Drucken 210 einer Druckpaste mit der Rakellippe durch das Sieb der Siebdruckmaschine zur Erzeugung einer Drucklage aus der Druckpaste auf einem Substrat, wobei die Rakel durch den zumindest einen Rakelantrieb mit Arbeitswinkel zur Z-Achse2ausgerichtet ist, und mit einer Arbeitskraft entlang der Y-Achse auf das Sieb gedrückt wird.

Das dargestellte Verfahren 200 umfasst den Schritt eines automatischen Bestimmens 220 des Flächeninhalts der Kontaktfläche mit dem zumindest einen Sensor nach dem Drucken 210 einer Anzahl von Drucklagen und den Schritt eines automatischen Nachstellens 230 der Arbeitskraft abhängig von dem Flächeninhalt zum Einstellen eines vorgegebenen Soll-Anpressdrucks der Rakellippe auf das Sieb nach dem Bestimmen 220.

Insbesondere können das Bestimmen 220 und das Nachstellen 230 regelmäßig jeweils nach dem Drucken 210 einer bestimmten Anzahl von Drucklagen erfolgen.

Das automatische Bestimmen 220 des Flächeninhalts kann ein automatisches Ermitteln 221 einer Abriebdicke der Rakellippe mit dem zumindest einen Sensor und ein automatisches Berechnen 222 der Kontaktfläche aus der Abriebdicke und einer Ursprungsform der Rakellippe umfasst.

Das Verfahren umfasst den Schritt eines automatischen Verstellens 260 des Arbeitswinkels um ein vorgegebenes Winkelintervall, sobald der Flächeninhalt einen Maximalflächeninhalt überschreitet und den Schritt eines automatischen Zurücksetztens 265 der Arbeitskraft zum Einstellen des Soll-Anpressdrucks nach dem Verstellen 260. Nach dem Zurücksetzen kann dann erneut ein Drucken 210 einer Anzahl von Drucklagen erfolgen.

Das Verfahren kann den Schritt eines automatischen Kontrollierens 240 zumindest einer physikalischen Eigenschaft einer mit der Siebdruckmaschine auf das Substrat gedruckten Schicht mit einer Kontrollvorrichtung der Siebdruckmaschine und den Schritt eines automatischen Anpassens 250 der Arbeitskraft, des Arbeitswinkels und/oder der Arbeitsgeschwindigkeit der Rakel und/oder eines Siebabstands zwischen dem Sieb und dem Substrat bei einer Abweichung der physikalischen Eigenschaft von einer zugehörigen Soll-Eigenschaft umfassen.

Die physikalische Eigenschaft umfasst beispielsweise eine Schichtdicke der Schicht entlang der Z-Achse, eine elektrische Leitfähigkeit der Schicht entlang der Z-Achse und/oder ein spezifischer Flächenwiderstand der Schicht und/oder eine Homogenität der Schichtdicke und/oder der elektrischen Leitfähigkeit entlang einer von der X-Achse und der Y-Achse aufgespannten XY-Ebene.

Nach dem Anpassen 250 kann wiederum ein Drucken 210 weiterer Drucklagen erfolgen.

### Liste der Bezugszeichen

| | | | |
|---|---|---|---|
| 100 | Siebdruckmaschine | 200 | Verfahren |
| 110 | Rakel | 210 | Drucken |
| 111 | Rakellippe | 220 | Bestimmen |
| 112 | Kontaktfläche | 221 | Ermitteln |
| 120 | Sieb | 222 | Berechnen |
| 121 | Siebantrieb | 230 | Nachstellen |
| 130, 130A-D | Rakelantrieb | 240 | Kontrollieren |
| 140 | Computergerät | 250 | Anpassen |
| 150 | Sensor | 260 | Verstellen |
| 160 | Druckplatte | 265 | Zurücksetzen |
| 161 | Druckplattenantrieb | d | Abriebdicke |
| 170 | Flutrakel | s | Abstand |
| 171, 171A-C | Flutrakelantrieb | X | X-Achse |
| 180 | Rahmen | Y | Y-Achse |
| 181 | Rahmenantrieb | Z | Z.Achse |
| 190 | Kontrollvorrichtung | α | Arbeitswinkel |
| | | β | Messwinkel |

## Patentansprüche

1. Computerimplementiertes Verfahren (200) zur Steuerung einer Siebdruckmaschine (100) mit
a) zumindest einem Sieb (120),
b) zumindest einer Rakel (110) mit einer an der Rakel (110) befestigten Rakellippe (111), wobei die Rakellippe (111) eine Kontaktfläche (112) mit einem Flächeninhalt zum Kontakt mit dem Sieb (120) umfasst,
c) zumindest einem Rakelantrieb (130) zur Translation der Rakel (110) relativ zu dem Sieb (120) entlang einer zu dem Sieb (120) parallelen X-Achse (X) und entlang einer zu dem Sieb (120) orthogonalen Z-Achse (Z) sowie zur Rotation der Rakel (110) relativ zu dem Sieb (120) um eine zur X-Achse (X) und zur Z-Achse (Z) orthogonalen Y-Achse (Y),
d) zumindest einem Computergerät (140) zur Steuerung der Siebdruckmaschine (100) und
e) zumindest einem kommunikativ mit dem Computergerät (140) verbundenen Sensor (150) zur Bestimmung des Flächeninhalts der Kontaktfläche (112) der Rakellippe (111),
f) wobei das Verfahren ein Drucken (210) einer Druckpaste mit der Rakellippe (111) durch das Sieb (120) zur Erzeugung einer Drucklage aus der Druckpaste auf einem Substrat umfasst, wobei die Rakel (110) durch den zumindest einen Rakelantrieb (130)
f1) mit einer Arbeitsgeschwindigkeit entlang der X-Achse (X) bewegt wird,
f2) in einem Arbeitswinkel (α) zur Z-Achse (Z) ausgerichtet ist, und
f3) mit einer Arbeitskraft entlang der Z-Achse (Z) auf das Sieb (120) gedrückt wird,
**gekennzeichnet durch folgende Schritte:**
g) automatisches Bestimmen (220) des Flächeninhalts der Kontaktfläche (112) der Rakellippe (111) mit dem zumindest einen Sensor (150) nach dem Drucken (210) einer Anzahl von Drucklagen und
h) automatisches Nachstellen (230) der Arbeitskraft abhängig von dem Flächeninhalt zum Einstellen eines vorgegebenen Soll-Anpressdrucks der Rakellippe (111) auf das Sieb (120) nach dem automatischen Bestimmen (220) des Flächeninhalts der Kontaktfläche (112) der Rakellippe (111) und
i) automatisches Verstellen (260) des Arbeitswinkels (α) um ein vorgegebenes Winkelintervall, sobald der Flächeninhalt einen Maximalflächeninhalt überschreitet, und
j) automatisches Zurücksetzen (265) der Arbeitskraft zum Einstellen des Soll-Anpressdrucks nach dem automatischen Verstellen (260) des Arbeitswinkels (α) um das vorgegebene Winkelintervall.

2. Verfahren nach Anspruch 1,
**dadurch gekennzeichnet, dass**
a) das automatische Verstellen (260) des Arbeitswinkels (α) in einer ersten Richtung erfolgt, bis der Arbeitswinkel (α) einen ersten Grenzwinkels passiert,
b) bei Passieren des ersten Grenzwinkels ein automatisches Zurücksetzen (265) des Arbeitswinkels (α) auf einen Ausgangswinkel vom Beginn des Druckens (210) erfolgt, und
c) das automatische Verstellen (260) nach dem Zurücksetzen (265) des Arbeitswinkels (α) in einer der ersten Richtung entgegengesetzten, zweiten Richtung erfolgt, bis der Arbeitswinkel (α) einen zweiten Grenzwinkel passiert.

3. Verfahren nach einem der Ansprüche 1 bis 2,
**dadurch gekennzeichnet, dass** das automatische Bestimmen (220) des Flächeninhalts
a) ein automatisches Ermitteln (221) einer Abriebdicke (d) der Rakellippe (111) mit dem zumindest einen Sensor (150) und
b) ein automatisches Berechnen (222) der Kontaktfläche aus der Abriebdicke (d) und einer Ursprungsform der Rakellippe (111) umfasst.

4. Verfahren nach Anspruch 3,
**dadurch gekennzeichnet, dass** das automatische Ermitteln (221) der Abriebdicke (d)
a) ein automatisches Messen eines Referenzabstands der Rakellippe (111) von dem zumindest einen Sensor (150) bei bekannter Referenzabriebdicke der Rakellippe (111),
b) ein automatisches Messen eines Abstands (s) der Rakellippe (111) von dem zumindest einen Sensor (150) und
c) ein automatisches Berechnen der Abriebdicke (d) aus der Referenzabriebdicke, dem Referenzabstand und dem Abstand (s) der Rakellippe (111) von dem zumindest einen Sensor (150) umfasst.

5. Verfahren nach Anspruch 4,
**dadurch gekennzeichnet, dass**
a) das automatische Messen des Referenzabstands erfolgt, während die Rakel (110) in einem Referenzmesswinkel zur Z-Achse (Z) ausgerichtet ist, und
b) das automatische Messen des Abstands (s) der Rakellippe (111) von dem zumindest einen Sensor (150) erfolgt, während die Rakel (110) in einem Messwinkel (β) zur Z-Achse (Z) ausgerichtet ist,
c) wobei der Referenzmesswinkel dem Messwinkel (β) entspricht.

6. Verfahren nach Anspruch 4 oder 5,
**dadurch gekennzeichnet, dass**
a) das automatische Messen des Referenzabstands erfolgt, während die Rakel (110) in einem Referenzmesswinkel zur Z-Achse (Z) ausgerichtet ist, und
b) das automatische Messen des Abstands (s) der Rakellippe (111) von dem zumindest einen Sensor (150) erfolgt, während die Rakel (110) in einem Messwinkel (β) zur Z-Achse (Z) ausgerichtet ist,
c) wobei der Referenzwinkel und/oder der Messwinkel (β) dem Arbeitswinkel (α) entspricht.

7. Verfahren nach Anspruch 6,
**dadurch gekennzeichnet, dass** das Messen des Referenzabstands und/oder des Abstands (s) der Rakellippe (111) von dem zumindest einen Sensor (150) erfolgt während die zumindest eine Rakel (110) mit Hilfe des zumindest einen Rakelantriebs (130) um die Y-Achse (Y) rotiert wird.

8. Verfahren nach einem der Ansprüche 1 bis 7,
**gekennzeichnet durch folgende Schritte:**
a) automatisches Kontrollieren (240) zumindest einer physikalischen Eigenschaft einer mit der Siebdruckmaschine (100) auf das Substrat gedruckten Schicht mit einer Kontrollvorrichtung (190) der Siebdruckmaschine (100), und
b) automatisches Anpassen (250) der Arbeitskraft, des Arbeitswinkels (α) und/oder der Arbeitsgeschwindigkeit der Rakel (110) und/oder eines Siebabstands zwischen dem Sieb (120) und dem Substrat bei einer Abweichung der physikalischen Eigenschaft von einer zugehörigen Soll-Eigenschaft,
c) wobei die physikalische Eigenschaft bevorzugt eine Schichtdicke der Schicht entlang der Z-Achse (Z), eine elektrische Leitfähigkeit der Schicht entlang der Z-Achse (Z) und/oder ein spezifischer Flächenwiderstand der Schicht und/oder eine Homogenität der Schichtdicke und/oder der elektrischen Leitfähigkeit entlang einer von der X-Achse (X) und der Y-Achse (Y) aufgespannten XY-Ebene umfasst.

9. Computergesteuerte Siebdruckmaschine (100) zur Ausführung eines
Verfahrens nach einem der Ansprüche 1 bis 8, mit
a) zumindest einem Sieb (120),
b) zumindest einer Rakel (110) mit einer an der Rakel (110) befestigten Rakellippe (111), wobei die Rakellippe (111) eine Kontaktfläche (112) mit einem Flächeninhalt zum Kontakt mit dem Sieb (120) umfasst,
c) zumindest einem Rakelantrieb (130) zur Translation der Rakel (110) relativ zu dem Sieb (120) entlang einer zu dem Sieb (120) parallelen X-Achse (X) und entlang einer zu dem Sieb (120) orthogonalen Z-Achse (Z) sowie zur Rotation der Rakel (110) relativ zu dem Sieb (120) um eine zur X-Achse (X) und zur Z-Achse (Z) orthogonalen Y-Achse (Y),
d) zumindest einem Computergerät (140) zur Steuerung der Siebdruckmaschine (100) und
e) zumindest einem kommunikativ mit dem Computergerät (140) verbundenen Sensor (150) zur Bestimmung des Flächeninhalts der Kontaktfläche (112) der Rakellippe (111).

10. Siebdruckmaschine (100) nach Anspruch 9,
**dadurch gekennzeichnet, dass** der zumindest eine Sensor (150) einen Abstandssensor, bevorzugt einen Laser-Abstandssensor, zur Messung eines Abstands (s) der Kontaktfläche (112) der Rakellippe (111) von dem zumindest einen Sensor (150) umfasst

11. Siebdruckmaschine (100) nach Anspruch 10,
**dadurch gekennzeichnet, dass** der zumindest eine Sensor (150) zur Abstandsmessung an zumindest zwei entlang der Y-Achse (Y) voneinander beabstandeten Bereichen der Rakellippe (111) ausgestaltet ist.

12. Siebdruckmaschine (100) nach einem der Ansprüche 9 bis 11,
**gekennzeichnet durch**
a) einen mit dem Computergerät (140) kommunikativ verbundenen Siebantrieb (121) zur Translation des Siebs (120) entlang der Z-Achse (Z) relativ zu dem Substrat,
b) einen mit dem Computergerät (140) kommunikativ verbundenen Druckplattenantrieb (161) zur Translation einer Druckplatte (160) zur Aufnahme des zu bedruckenden Substrats entlang der X-Achse relativ zu dem Sieb (120),
c) zumindest eine Flutrakel (170) zur Verteilung der Druckpaste auf dem Sieb (120) und einen mit dem Computergerät (140) kommunikativ verbundenen Flutrakelantrieb (171) zur Translation der Flutrakel (170) relativ zu dem Sieb (120) entlang der X-Achse (X) und entlang der Z-Achse (Z) sowie zur Rotation der Flutrakel (170) relativ zu dem Sieb (120) um die Y-Achse (Y) und/oder
d) zumindest einen die zumindest eine Rakel (110) und die zumindest eine Flutrakel (170) tragenden Rahmen (180) und einen mit dem Computergerät (140) kommunikativ verbundenen Rahmenantrieb (181) zur Translation des Rahmens (180) relativ zu dem Sieb (120) entlang der Z-Achse (Z).

13. Siebdruckmaschine (100) nach Anspruch 12,
**dadurch gekennzeichnet, dass** der zumindest eine Rakelantrieb (130), der Siebantrieb (121), der Druckplattenantrieb (161),
der Flutrakelantrieb (171) und/oder der Rahmenantrieb (181) eine Anzahl von mit dem Computergerät (140) kommunikativ verbundenen Elektromotoren, bevorzugt Servomotoren, umfasst.

14. Siebdruckmaschine (100) nach einem der Ansprüche 9 bis 13,
**gekennzeichnet durch**
zumindest eine kommunikativ mit dem Computergerät (140) verbundene Kontrollvorrichtung (190) zur Kontrolle zumindest einer physikalischen Eigenschaft einer mit der Siebdruckmaschine (100) auf das Substrat gedruckten Schicht, wobei die physikalische Eigenschaft bevorzugt eine Schichtdicke der Schicht entlang der Z-Achse (Z), eine elektrische Leitfähigkeit der Schicht entlang der Z-Achse (Z) und/oder ein spezifischer Flächenwiderstand der Schicht und/oder eine Homogenität der Schichtdicke und/oder der elektrischen Leitfähigkeit entlang einer von der X-Achse (X) und der Y-Achse (Y) aufgespannten XY-Ebene umfasst.

## Claims

1. A computer-implemented method (200) for controlling a screen printing machine (100) comprising
a) at least one screen (120),
b) at least one squeegee (110) having a squeegee lip (111) fastened to the squeegee (110), wherein the squeegee lip (111) comprises a contact surface (112) having a surface area for contacting the screen (120),
c) at least one squeegee drive (130) for translating the squeegee (110) relative to the screen (120) along an X-axis (X) parallel to the screen (120) and along a Z-axis (Z) orthogonal to the screen (120) as well as for rotating the squeegee (110) relative to the screen (120) about a Y-axis (Y) orthogonal to the X-axis (X) and to the Z-axis (Z),
d) at least one computer apparatus (140) for controlling the screen printing machine (100), and
e) at least one sensor (150) communicatively connected to the computer apparatus (140) for determining the surface area of the contact surface (112) of the squeegee lip (111),
f) wherein the method comprises a printing (210) of a printing paste with the squeegee lip (111) through the screen (120) in order to produce a print coating made up of the printing paste on a substrate, wherein, thanks to the at least one squeegee drive (130), the squeegee (110)
f1) is moved along the X-axis (X) at a working speed,
f2) is aligned to the Z-axis (Z) at a working angle (α), and
f3) is pressed onto the screen (120) with a working force along the Z-axis (Z),
**characterized by** the following steps:
g) automatic determination (220) of the surface area of the contact surface (112) of the squeegee lip (111) with the at least one sensor (150) following the printing (210) of a number of print coatings, and
h) automatic readjustment (230) of the working force depending on the surface area in order to set a predefined nominal contact pressure of the squeegee lip (111) onto the screen (120) following the automatic determination (220) of the surface area of the contact surface (112) of the squeegee lip (111), and
i) automatic adjustment (260) of the working angle (α) by a predefined angular interval as soon as the surface area exceeds a maximum surface area, and
j) automatic resetting (265) of the working force in order to set the nominal contact pressure following the automatic adjustment (260) of the working angle (α) by the predefined angular interval.

2. The method according to Claim 1,
**characterized in that**
a) the automatic adjustment (260) of the working angle (α) is carried out in a first direction until the working angle (α) passes a first critical angle,
b) when the first critical angle is passed, an automatic resetting (265) of the working angle (α) to an initial angle from the start of the printing (210) is carried out, and
c) the automatic adjustment (260) is carried out, following the resetting (265) of the working angle (α), in a second direction opposite the first direction until the working angle (α) passes a second critical angle.

3. The method according to any one of Claims 1 to 2,
**characterized in that**
the automatic determination (220) of the surface area comprises
a) an automatic establishment (221) of an abrasion thickness (d) of the squeegee lip (111) with the at least one sensor (150), and
b) an automatic calculation (222) of the contact surface from the abrasion thickness (d) and an original shape of the squeegee lip (111).

4. The method according to Claim 3,
**characterized in that**
the automatic establishment (221) of the abrasion thickness (d) comprises
a) an automatic measurement of a reference distance of the squeegee lip (111) from the at least one sensor (150) when the reference abrasion thickness of the squeegee lip (111) is known,
b) an automatic measurement of a distance (s) of the squeegee lip (111) from the at least one sensor (150), and
c) an automatic calculation of the abrasion thickness (d) from the reference abrasion thickness, the reference distance and the distance (s) of the squeegee lip (111) from the at least one sensor (150).

5. The method according to Claim 4,
**characterized in that**
a) the automatic measurement of the reference distance is carried out while the squeegee (110) is aligned at a reference measurement angle to the Z-axis (Z), and
b) the automatic measurement of the distance (s) of the squeegee lip (111) from the at least one sensor (150) is carried out while the squeegee (110) is aligned at a measurement angle (β) to the Z-axis (Z),
c) wherein the reference measurement angle corresponds to the measurement angle (β).

6. The method according to Claim 4 or 5,
**characterized in that**
a) the automatic measurement of the reference distance is carried out while the squeegee (110) is aligned at a reference measurement angle to the Z-axis (Z), and
b) the automatic measurement of the distance (s) of the squeegee lip (111) from the at least one sensor (150) is carried out while the squeegee (110) is aligned at a measurement angle (β) to the Z-axis (Z),
c) wherein the reference angle and/or the measurement angle (β) correspond(s) to the working angle (α).

7. The method according to Claim 6,
**characterized in that**
the measurement of the reference distance and/or of the distance (s) of the squeegee lip (111) from the at least one sensor (150) is carried out while the at least one squeegee (110) is rotated with the aid of the at least one squeegee drive (130) about the Y-axis (Y).

8. The method according to any one of Claims 1 to 7,
**characterized by** the following steps:
a) automatic monitoring (240) of at least one physical property of a layer printed onto the substrate with the screen printing machine (100) with a monitoring device (190) of the screen printing machine (100), and
b) automatic adaptation (250) of the working force, the working angle (α) and/or the working speed of the squeegee (110) and/or of a screen distance between the screen (120) and the substrate in the event of a deviation of the physical property from an associated nominal property,
c) wherein the physical property preferably comprises a layer thickness of the layer along the Z-axis (Z), an electric conductivity of the layer along the Z-axis (Z) and/or a specific sheet resistance of the layer and/or a homogeneity of the layer thickness and/or the electric conductivity along an XY plane spanned by the X-axis (X) and the Y-axis (Y).

9. A computer-controlled screen printing machine (100) for executing a
method according to any one of Claims 1 to 8, comprising
a) at least one screen (120),
b) at least one squeegee (110) having a squeegee lip (111) fastened to the squeegee (110), wherein the squeegee lip (111) comprises a contact surface (112) having a surface area for contacting the screen (120),
c) at least one squeegee drive (130) for translating the squeegee (110) relative to the screen (120) along an X-axis (X) parallel to the screen (120) and along a Z-axis (Z) orthogonal to the screen (120) as well as for rotating the squeegee (110) relative to the screen (120) about a Y-axis (Y) orthogonal to the X-axis (X) and to the Z-axis (Z),
d) at least one computer apparatus (140) for controlling the screen printing machine (100), and
e) at least one sensor (150) communicatively connected to the computer apparatus (140) for determining the surface area of the contact surface (112) of the squeegee lip (111).

10. The screen printing machine (100) according to Claim 9,
**characterized in that**
the at least one sensor (150) comprises a distance sensor, preferably a laser distance sensor, for measuring a distance (s) of the contact surface (112) of the squeegee lip (111) from the at least one sensor (150).

11. The screen printing machine (100) according to Claim 10,
**characterized in that**
the at least one sensor (150) is configured to measure the distance in at least two regions of the squeegee lip (111) spaced apart from one another along the Y-axis (Y).

12. The screen printing machine (100) according to any one of Claims 9 to 11,
**characterized by**
a) a screen drive (121) communicatively connected to the computer apparatus (140) for translating the screen (120) along the Z-axis (Z) relative to the substrate,
b) a printing plate drive (161) communicatively connected to the computer apparatus (140) for translating a printing plate (160) for receiving the substrate to be printed along the X-axis relative to the screen (120),
c) at least one flood squeegee (170) for distributing the printing paste on the screen (120) and a flood squeegee drive (171) communicatively connected to the computer apparatus (140) for translating the flood squeegee (170) relative to the screen (120) along the X-axis (X) and along the Z-axis (Z) as well as for rotating the flood squeegee (170) relative to the screen (120) about the Y-axis (Y), and/or
d) at least one frame (180) carrying the at least one squeegee (110) and the at least one flood squeegee (170) and a frame drive (181) communicatively connected to the computer apparatus (140) for translating the frame (180) relative to the screen (120) along the Z-axis (Z).

13. The screen printing machine (100) according to Claim 12,
**characterized in that**
the at least one squeegee drive (130), the screen drive (121), the printing plate drive (161), the flood squeegee drive (171) and/or the frame drive (181) comprise(s) a number of electric motors, preferably servo motors, communicatively connected to the computer apparatus (140).

14. The screen printing machine (100) according to any one of Claims 9 to 13,
**characterized by**
at least one monitoring device (190) communicatively connected to the computer apparatus (140) for monitoring at least one physical property of a layer printed onto the substrate with the screen printing machine (100), wherein the physical property preferably comprises a layer thickness of the layer along the Z-axis (Z) , an electric conductivity of the layer along the Z-axis (Z) and/or a specific sheet resistance of the layer and/or a homogeneity of the layer thickness and/or the electric conductivity along an XY plane spanned by the X-axis (X) and the Y-axis (Y).

## Revendications

1. Procédé mis en oeuvre par ordinateur (200) permettant de commander une machine d'impression par sérigraphie (100) comprenant
a) au moins un tamis (120),
b) au moins un racloir (110) doté d'une lèvre de racloir (111) fixée au racloir (110), dans lequel la lèvre de racloir (111) comporte une surface de contact (112) avec une aire destinée à être en contact avec le tamis (120),
c) au moins un entraînement de racloir (130) pour la translation du racloir (110) par rapport au tamis (120) le long d'un axe X (X) parallèle au tamis (120) et le long d'un axe Z (Z) orthogonal au tamis (120) ainsi que pour la rotation du racloir (110) par rapport au tamis (120) autour d'un axe Y (Y) orthogonal à l'axe X (X) et à l'axe Z (Z),
d) au moins un appareil informatique (140) destiné à commander la machine d'impression par sérigraphie (100) et
e) au moins un capteur (150) relié en communication à l'appareil informatique (140) pour la détermination de l'aire de la surface de contact (112) de la lèvre de racloir (111),
f) dans lequel le procédé comporte une impression (210) d'une pâte d'impression avec la lèvre de racloir (111) à travers le tamis (120) pour la réalisation d'une couche d'impression à partir de la pâte d'impression sur un substrat, dans lequel le racloir (110) est, à l'aide de l'au moins un entraînement de racloir (130),
f1) déplacé à une vitesse de travail le long de l'axe X (X),
f2) orienté selon un angle de travail (α) par rapport à l'axe Z (Z), et
f3) pressé sur le tamis (120) avec une force de travail le long de l'axe Z (Z), **caractérisé par** les étapes suivantes :
g) détermination automatique (220) de l'aire de la surface de contact (112) de la lèvre de racloir (111) avec l'au moins un capteur (150) après l'impression (210) d'un certain nombre de couches d'impression et
h) réajustement automatique (230) de la force de travail en fonction de l'aire pour le réglage d'une pression d'application de consigne prédéfinie de la lèvre de racloir (111) sur le tamis (120) après la détermination automatique (220) de l'aire de la surface de contact (112) de la lèvre de racloir (111) et
i) modification automatique (260) de l'angle de travail (α) selon un intervalle d'angle prédéfini, dès que l'aire dépasse une aire maximale, et
j) restauration automatique (265) de la force de travail pour le réglage de la pression d'application de consigne après la modification automatique (260) de l'angle de travail (α) selon l'intervalle d'angle prédéfini.

2. Procédé selon la revendication 1,
**caractérisé en ce que**
a) la modification automatique (260) de l'angle de travail (α) est effectuée dans une première direction, jusqu'à ce que l'angle de travail (α) atteigne un premier angle limite,
b) lors de l'atteinte du premier angle limite, une restauration automatique (265) de l'angle de travail (α) à un angle initial de début d'impression (210) est effectuée, et
c) la modification automatique (260) après la restauration (265) de l'angle de travail (α) est effectuée dans une deuxième direction opposée à la première direction, jusqu'à ce que l'angle de travail (α) atteigne un deuxième angle limite.

3. Procédé selon l'une des revendications 1 à 2,
**caractérisé en ce que**
la détermination automatique (220) de l'aire comporte
a) une détection automatique (221) d'une épaisseur de frottement (d) de la lèvre de racloir (111) à l'aide de l'au moins un capteur (150) et
b) un calcul automatique (222) de la surface de contact à partir de l'épaisseur de frottement (d) et d'une forme initiale de la lèvre de racloir (111).

4. Procédé selon la revendication 3,
**caractérisé en ce que**
la détermination automatique (221) de l'épaisseur de frottement (d) comporte
a) une mesure automatique d'une distance de référence de la lèvre de racloir (111) par rapport à l'au moins un capteur (150) avec une épaisseur de frottement de référence connue de la lèvre de racloir (111),
b) une mesure automatique d'une distance (s) de la lèvre de racloir (111) par rapport à l'au moins un capteur (150) et
c) un calcul automatique de l'épaisseur de frottement (d) à partir de l'épaisseur de frottement de référence, de la distance de référence et de la distance (s) de la lèvre de racloir (111) par rapport à l'au moins un capteur (150).

5. Procédé selon la revendication 4,
**caractérisé en ce que**
a) la mesure automatique de la distance de référence est effectuée pendant que le racloir (110) est orienté selon un angle de mesure de référence par rapport à l'axe Z (Z), et
b) la mesure automatique de la distance (s) de la lèvre de racloir (111) par rapport à l'au moins un capteur (150) est effectuée pendant que le racloir (110) est orienté selon un angle de mesure (β) par rapport à l'axe Z (Z),
c) dans lequel l'angle de mesure de référence correspond à l'angle de mesure (β).

6. Procédé selon la revendication 4 ou 5,
**caractérisé en ce que**
a) la mesure automatique de la distance de référence est effectuée pendant que le racloir (110) est orienté selon un angle de mesure de référence par rapport à l'axe Z (Z), et
b) la mesure automatique de la distance (s) de la lèvre de racloir (111) par rapport à l'au moins un capteur (150) est effectuée pendant que le racloir (110) est orienté selon un angle de mesure (β) par rapport à l'axe Z (Z),
c) dans lequel l'angle de référence et/ou l'angle de mesure (β) correspond à l'angle de travail (α).

7. Procédé selon la revendication 6,
**caractérisé en ce que**
la mesure de la distance de référence et/ou de la distance (s) de la lèvre de racloir (111) par rapport à l'au moins un capteur (150) est effectuée pendant que l'au moins un racloir (110) est mis en rotation autour de l'axe Y (Y) à l'aide de l'au moins un entraînement de racloir (130).

8. Procédé selon l'une des revendications 1 à 7,
**caractérisé par** les étapes suivantes :
a) contrôle automatique (240) d'au moins une propriété physique d'une couche imprimée sur le substrat avec la machine d'impression par sérigraphie (100) à l'aide d'un dispositif de contrôle (190) de la machine d'impression par sérigraphie (100), et
b) adaptation automatique (250) de la force de travail, de l'angle de travail (α) et/ou de la vitesse de travail du racloir (110) et/ou d'une distance de tamis entre le tamis (120) et le substrat lorsque la propriété physique s'écarte d'une propriété de consigne associée,
c) dans lequel la propriété physique comporte de préférence une épaisseur de couche de la couche le long de l'axe Z (Z), une conductivité électrique de la couche le long de l'axe Z (Z) et/ou une résistance de surface spécifique de la couche et/ou une homogénéité de l'épaisseur de couche et/ou de la conductivité électrique le long d'un plan XY déployé par l'axe X (X) et l'axe Y (Y).

9. Machine d'impression par sérigraphie (100) commandée par ordinateur pour la mise en oeuvre d'un procédé selon l'une des revendications 1 à 8, comprenant
a) au moins un tamis (120),
b) au moins un racloir (110) doté d'une lèvre de racloir (111) fixée au racloir (110), dans laquelle la lèvre de racloir (111) comporte une surface de contact (112) avec une aire destinée à être en contact avec le tamis (120),
c) au moins un entraînement de racloir (130) pour la translation du racloir (110) par rapport au tamis (120) le long d'un axe X (X) parallèle au tamis (120) et le long d'un axe Z (Z) orthogonal au tamis (120) ainsi que pour la rotation du racloir (110) par rapport au tamis (120) autour d'un axe Y (Y) orthogonal à l'axe X (X) et à l'axe Z (Z),
d) au moins un appareil informatique (140) destiné à commander la machine d'impression par sérigraphie (100) et
e) au moins un capteur (150) relié en communication à l'appareil informatique (140) pour la détermination de l'aire de la surface de contact (112) de la lèvre de racloir (111).

10. Machine d'impression par sérigraphie (100) selon la revendication 9, **caractérisée en ce que**
l'au moins un capteur (150) comporte un capteur de distance, de préférence un capteur de distance laser, pour la mesure d'une distance (s) de la surface de contact (112) de la lèvre de racloir (111) par rapport à l'au moins un capteur (150).

11. Machine d'impression par sérigraphie (100) selon la revendication 10, **caractérisée en ce que**
pour la mesure de la distance, l'au moins un capteur (150) est conçu dans au moins deux régions de la lèvre de racloir (111) espacées les unes des autres le long de l'axe Y (Y).

12. Machine d'impression par sérigraphie (100) selon l'une des revendications 9 à 11, **caractérisée par**
a) un entraînement de tamis (121) relié en communication à l'appareil informatique (140) pour la translation du tamis (120) le long de l'axe Z (Z) par rapport au substrat,
b) un entraînement de plaque d'impression (161) relié en communication à l'appareil informatique (140) pour la translation d'une plaque d'impression (160) destinée à recevoir le substrat à imprimer le long de l'axe X par rapport au tamis (120),
c) au moins un racloir à déplacement (170) pour la répartition de la pâte d'impression sur le tamis (120) et un entraînement de racloir à déplacement (171) relié en communication à l'appareil informatique (140) pour la translation du racloir à déplacement (170) par rapport au tamis (120) le long de l'axe X (X) et le long de l'axe Z (Z) ainsi que pour la rotation du racloir à déplacement (170) par rapport au tamis (120) autour de l'axe Y (Y) et/ou
d) au moins un cadre (180) portant l'au moins un racloir (110) et l'au moins un racloir à déplacement (170) et un entraînement de cadre (181) relié en communication à l'appareil informatique (140) pour la translation du cadre (180) par rapport au tamis (120) le long de l'axe Z (Z).

13. Machine d'impression par sérigraphie (100) selon la revendication 12, **caractérisée en ce que**
l'au moins un entraînement de racloir (130), l'entraînement de tamis (121), l'entraînement de plaque d'impression (161), l'entraînement de racloir à déplacement (171) et/ou l'entraînement de cadre (181) comportent un certain nombre de moteurs électriques, de préférence des servomoteurs, reliés en communication à l'appareil informatique (140).

14. Machine d'impression par sérigraphie (100) selon l'une des revendications 9 à 13, **caractérisée par**
au moins un dispositif de contrôle (190) relié en communication à l'appareil informatique (140) pour le contrôle d'au moins une propriété physique d'une couche imprimée sur le substrat avec la machine d'impression par sérigraphie (100), dans laquelle la propriété physique comporte de préférence une épaisseur de couche de la couche le long de l'axe Z (Z), une conductivité électrique de la couche le long de l'axe Z (Z) et/ou une résistance de surface spécifique de la couche et/ou une homogénéité de l'épaisseur de couche et/ou de la conductivité électrique le long d'un plan XY déployé par l'axe X (X) et l'axe Y (Y).
